Europäisches Patentamt

European Patent Office

Office européen des brevets

(19)

(11) Numéro de publication : **0 453 034 B1**

(12)
# FASCICULE DE BREVET EUROPEEN

(45) Date de publication du fascicule du brevet :
26.07.95 Bulletin 95/30

(51) Int. Cl.⁶ : **H03F 1/32**

(21) Numéro de dépôt : **91200878.6**

(22) Date de dépôt : **15.04.91**

(54) **Circuit différentiel compensé en distortion.**

(30) Priorité : **19.04.90 FR 9005009**

(43) Date de publication de la demande :
**23.10.91 Bulletin 91/43**

(45) Mention de la délivrance du brevet :
**26.07.95 Bulletin 95/30**

(84) Etats contractants désignés :
**DE FR GB IT**

(56) Documents cités :
EP-A- 0 208 365
DE-A- 3 138 078
FR-A- 2 462 817
US-A- 3 678 404
US-A- 4 794 348
US-A- 4 820 997
US-E- 30 572

(56) Documents cités :
**IEEE JOURNAL OF SOLID-STATE CIRCUITS.
vol. 23, no. 3, juin 1988, NEW YORK US pages
802 - 815; R.F. Wassenaar et al: "New Techniques for High-Frequency RMS-to-DC Conversion Based on a Multifunctional V-to-I
Convertor."**

(73) Titulaire : **PHILIPS COMPOSANTS
4, rue du Port aux Vins
F-92150 Suresnes (FR)**
(84) **FR**
Titulaire : **Philips Electronics N.V.
Groenewoudseweg 1
NL-5621 BA Eindhoven (NL)**
(84) **DE GB IT**

(72) Inventeur : **Marie, Hervé
Société Civile S.P.I.D.,
156, Boulevard Haussmann
F-75008 Paris (FR)**

(74) Mandataire : **Charpail, François et al
Société Civile S.P.I.D.
156, Boulevard Haussmann
F-75008 Paris (FR)**

EP 0 453 034 B1

# Description

La présente invention a pour objet un circuit différentiel compensé en distortion et comportant d'une part un étage différentiel comportant un premier et un deuxième transistor dont les émetteurs sont couplés par une première impédance ainsi qu'une source de signal d'entrée, et d'autre part un circuit de compensation de distortion comportant d'une part en série entre l'émetteur du premier transistor et une première source de courant une première diode ainsi que le trajet de courant principal d'un troisième transistor et d'autre part en série entre l'émetteur du deuxième transistor et une deuxième source de courant une deuxième diode ainsi que le trajet de courant principal d'un quatrième transistor, le troisième et le quatrième transistor ayant leur base et leur collecteur respectivement interconnectés et ayant leurs émetteurs couplés par une deuxième impédance.

Un tel circuit différentiel est connu de l'antériorité US 4 682 098 sous la forme d'un convertisseur tension-courant présentant une source de tension V, la première impédance étant constituée par une résistance convertissant ladite tension en un courant, lequel est amplifié par un circuit translinéaire à quatre transistors. Le premier et le deuxième transistors ont leurs collecteurs ainsi que leurs bases interconnectés. Pour compenser la non-linéarité de conversion due à la non-linéarité de la résistance d'émetteur des premier et deuxième transistor, le brevet US 4 682 098 enseigne de disposer entre les émetteurs des troisième et quatrième transistors, une résistance de valeur égale à celle de la première résistance.

Cette compensation procure des résultats tout à fait remarquables tant qu'on reste dans le domaine des petits signaux.

Le besoin se fait cependant sentir, en particulier dans le domaine des convertisseurs analogique-numérique du type flash à repliement et interpolation, de disposer de compensations sur une très large plage dynamique, jusqu'à des niveaux de plusieurs volts en sortie d'un amplificateur différentiel.

L'invention propose de réaliser une telle compensation.

Dans ce but, la deuxième impédance a une valeur nominale inférieure à celle de la première impédance.

Ainsi qu'il sera montré par la suite, cette modification très simple permet d'améliorer les valeurs de distortions en compensant les courants de base des troisième et quatrième transistor, au moins dans une certaine mesure.

Selon une variante préféré le circuit est caractérisé en ce que le rapport de la deuxième impédance et la première impédance est comprise entre les valeurs 0,65 et 0,85.

Selon une première variante, dérivée du brevet US 4 468 098 précité, l'étage différentiel est agencé pour constituer un convertisseur tension-courant, lesdites bornes d'entrée étant disposées en série avec la première impédance.

Selon une deuxième variante, l'étage différentiel est agencé pour constituer un suiveur différentiel, la base des premier et deuxième transistors constituant lesdites bornes d'entrée.

L'invention concerne également un circuit suiveur multiple, utilisable en particulier dans des convertisseurs analogique-numérique du type flash à repliement et interpolation.

Un tel circuit suiveur multiple comporte une pluralité de circuits suiveurs différentiels tels que définis ci-dessus, les premier, deuxième, troisième et quatrième transistors du circuit suiveur différentiel de rang i étant dénommés respectivement

$$T_i^A, \quad T_{\bar{i}}^A, \quad T_i^C \text{ et } T_{\bar{i}}^C,$$

et il comporte des premières impédances connectées entre les émetteurs d'au moins certains des transistors d'un premier groupe comprenant les premier et deuxième transistor et dont l'admittance est notée Y suivi de deux indices correspondant à ceux des deux transistors du premier groupe entre les émetteurs desquels ladite impédance est connectée, et des deuxièmes impédances connectées entre les émetteurs d'au moins certains des transistors d'un deuxième groupe comprenant les troisième et quatrième transistors et dont l'admittance est notée Y' suivi de deux indices correspondant aux deux transistors dudit deuxième groupe entre les émetteurs desquels ladite deuxième impédance est connectée et on a quelque soit i, j, $\bar{i}$, et $\bar{j}$ :

$$Y_{ij} = Y_{\bar{i}j} > Y'_{ij} = Y'_{\bar{i}j}$$
$$Y_{i\bar{j}} = Y_{\bar{i}\bar{j}} > Y'_{i\bar{j}} = Y'_{\bar{i}\bar{j}}$$

L'invention sera mieux comprise à la lecture de la description qui va suivre donnée à titre d'exemple non limitatif en liaison avec les dessins qui représentent :

- la figure 1, un convertisseur tension-courant selon le brevet US 4 682 098,
- la figure 2 un circuit suiveur différentiel de l'art antérieur
- la figure 3 un circuit suiveur différentiel selon un mode de réalisation préféré de l'invention,
- les figures 4 et 5 des courbes illustrant l'optimisation de la distortion
- la figure 6 un circuit suiveur multiple selon l'invention.

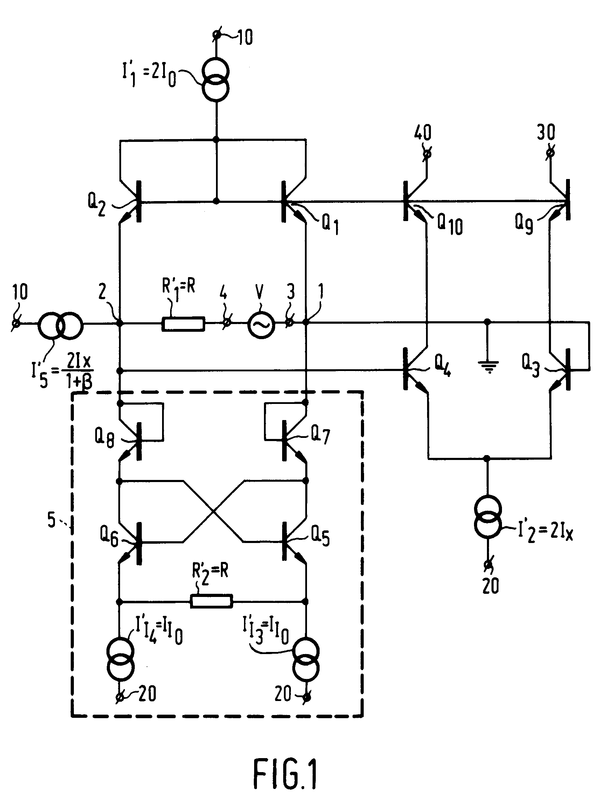

Selon la figure 1, un convertisseur tension-courant comporte une source de courant $I'_1$ (de valeur $2I_0$) couplé par un transistor $Q_1$ monté en diode à une borne 1 portée à un potentiel de référence et par un transistor $Q_2$ monté en diode à une borne 2. Les bases de transistors $Q_3$ et $Q_4$ sont couplées respectivement aux bornes 1 et 2. Les émetteurs des transistors $Q_3$ et $Q_4$ sont couplés à une source de courant $I'_2$ (de valeur $2I_x$). Une source de tension V et une résistance $R_1$ sont disposées en série entre les bornes 1 et 2, la résistance $R_1$ réalisant une conversion tension-courant. Le courant est amplifié par le circuit translinéaire ($Q_1$, $Q_2$, $Q_3$ et $Q_4$) et est fourni en sortie par les transistors $Q_9$ et $Q_{10}$. Un circuit de compensation 5 est prévu pour corriger la non-linéarité des résistance d'émetteur $R_e\ Q_1$ et $R_e\ Q_2$ respectivement des transistors $Q_1$ et $Q_2$.

Ce circuit comprend en série entre la borne 1 et une source de courant $I'_3$ (de valeur $I_0$) un transistor $Q_7$ monté en diode et le trajet de courant principal d'un transistor $Q_5$. Il comprend également en série entre la borne 2 et une source de courant $I'_4$ (de valeur $I_0$), un transistor $Q_8$ monté en diode et le trajet de courant principal d'un transistor $Q_6$.

Les transistors $Q_5$ et $Q_6$ ont leur base et leur collecteur respectivement interconnectés.

Pour réaliser la compensation des résistances d'émetteur $R_e\ Q_1$ et $R_e\ Q_2$, une résistance $R'_2$ de même valeur R que la résistance $R'_1$ est connectée entre les émetteurs des transistors $Q_5$ et $Q_6$.

Comme on va maintenant le montrer, le besoin se fait également sentir de compenser les résistances d'émetteur des suiveurs différentiel.

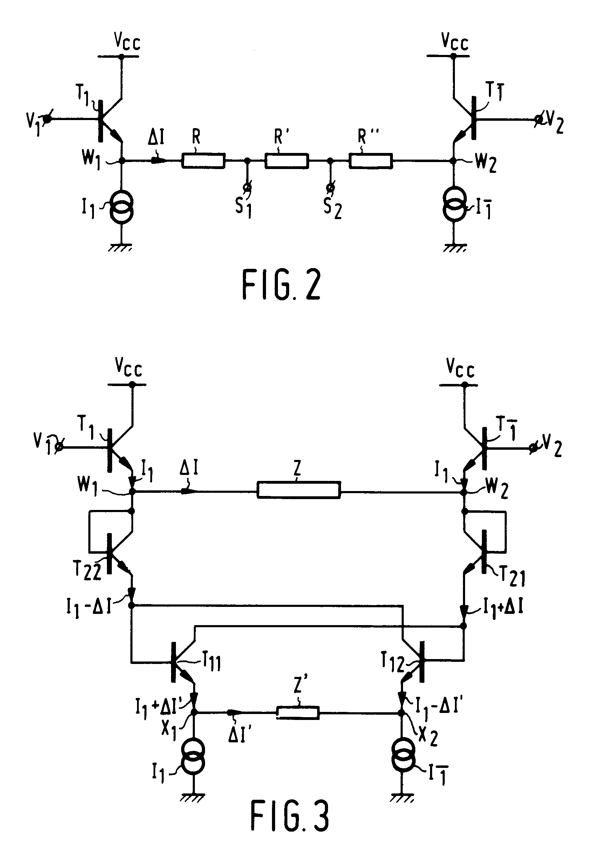

Un circuit suiveur différentiel de l'art antérieur (fig. 2) comporte des transistors T et $\overline{T_1}$, ici de type npn, dont le collecteur est connecté à une source de tension d'alimentation $V_{cc}$, dont la base est agencée pour recevoir un signal d'entrée différentiel, respectivement $V_1$ et $V_2$ et dont les émetteurs sont reliés entre eux par une chaîne de résistances en série R, R', R''. Deux sources de courant de même intensité $I_1$ et $\overline{I_1}$ sont connectées aux émetteurs respectivement des transistors $T_1$ et $\overline{T_1}$. Les points communs aux résistances R et R' d'une part et R' et R'' d'autre part, constituent des sorties $S_1$ et $S_2$ qui sont des tensions intermédiaires entre les tensions $V_1$ et $V_2$. De telles tensions intermédiaires sont mises en oeuvre dans des convertisseurs analogiques-numériques à repliement et interpolation.

De tels convertisseurs sont par exemple décrits dans le mémoire de Rudy J. van de Plassche "High Speed and High Resolution A/D and D/A converters" Ph. D. Thesis University of Technology (Delft-Pays-Bas édité en octobre 1989). Les signaux intermédiaires sont dans ce cas les signaux du codeur qui sont interpolés à partir des signaux de repliement. Dans de tels convertisseurs, il est besoin de niveaux de tension élevés (par exemple plusieurs Volts) avec une bonne linéarité, laquelle est essentielle pour les performance desdits convertisseurs.

Le trajet collecteur-émetteur des transistors $\overline{T_1}$ et $T_1$ est traversé par des courants respectivement $\overline{I_1} - \Delta I$ et $I_1 + \Delta I$, $\Delta I$ désignant le courant traversant les résistances R, R' et R'', de l'émetteur de $T_1$ vers celui de $\overline{T_1}$. Il en résulte que les signaux $V_1$ et $V_2$ ne peuvent être correctement recopiés sur les émetteurs de $T_1$ et $\overline{T_1}$ (signaux respectivement $W_1$ et $W_2$) que si $I_1$ est très supérieur à $\Delta I$. En outre, comme les courants à travers $T_1$ et $\overline{T_1}$ varient, les appels de courant de base peuvent être importants en dynamique, sauf si $I_1$ est supérieur à $\Delta I$.

La distorsion (en valeur absolue) $D_1$ de ce montage a pour valeur :

$$D_1 = (V_1 - V_2) - (W_1 - W_2) = V_T \, \text{Log} \, \frac{I_1 + \Delta I}{I_1 - \Delta I} + 2 \left( \frac{R_B}{\beta + 1} + R_E \right) \Delta I$$

$R_B$ et $R_E$ désignant les résistances d'accès à la base et à l'émetteur, et $\beta$ le gain en courant desdits transistors ; et $V_T = 26$ mV.

Selon la figure 3 entre les émetteurs des transistors $T_1$ et $\overline{T_1}$ et les sources de courant $I_1$ et $\overline{I_1}$ est disposé le trajet base-émetteur de deux transistors $T_{11}$ et $T_{12}$ dont la base et le collecteur sont interconnectés de manière croisée, c'est-à-dire que le collecteur de $T_{11}$ est connecté à la base de $T_{12}$, et le collecteur de $T_{12}$ à la base de $T_{11}$. Les émetteurs des transistors $T_1$, $\overline{T_1}$ sont reliés par une impédance Z et ceux des transistors $T_{11}$ et $T_{12}$ par une impédance Z' qui selon l'enseignement du brevet US 4 682 098 serait de même valeur que Z. L'impédance Z peut être par exemple une chaîne de résistances telles que les résistances R R' et R'' de la figure 2. Des diodes $T_{21}$ et $T_{22}$ sont connectées en série avec les trajets de courant principal (collecteur-émetteur) des transistors respectivement $T_{11}$ et $T_{12}$.

Les émetteurs des transistors $T_1$ et $\overline{T_1}$ doivent maintenir toujours le même courant $I_1$. Il en résulte que les appels de courant en dynamique sur la base de $T_1$ et celle de $\overline{T_1}$ sont moindres. D'autre part comme $I_1$ ne doit plus nécessairement être très supérieur à $\Delta I$, il est possible de mettre en oeuvre des transistors $T_1$ et $\overline{T_1}$ de plus faibles dimensions qu'auparavant, ce qui diminue encore les appels de courant en dynamique sur les entrées. Cependant, une telle compensation ne fonctionne de manière correcte que pour des signaux de relativement petite amplitude.

A la figure 3, deux transistors $T_{22}$ et $T_{21}$ montés en diode par court-circuit base-collecteur sont interposés entre respectivement l'émetteur du transistor $T_1$ et la base du transistor $T_{11}$ d'une part, et l'émetteur du transistor $T_1^-$ et la base du transistor $T_{12}$. Lorsque $T_{21}$, $T_{11}$, $T_{22}$ et $T_{12}$ ont les mêmes dimensions (même tension base-émetteur pour le même courant), alors les chutes de tension base-émetteur cumulées dans $T_{21}$ et $T_{11}$ d'une part et $T_{22}$ et $T_{12}$ d'autre part ont la même valeur (en négligeant l'influence des courants de base) d'où réduction de la distorsion.

Soit $D_3$ la distorsion (en valeur) absolue de ce montage.

On a

$$D_3 = (V_1 - V_2) - (W_1 - W_2)$$

Posons :

$$E = (W_1 - W_2) - (X_1 - X_2)$$

Le courant traversant l'émetteur de $T_{11}$ vaut $I_1 + \Delta I_1'$ donc son courant de base vaut $\dfrac{I_1 + \Delta I'}{\beta + 1}$ et son courant de collecteur vaut $(I_1 + \Delta I') \dfrac{\beta}{\beta + 1}$, $\beta$ désignant le gain en courant d'un transistor.

Le courant traversant l'émetteur de $T_{12}$ vaut $I_1 - \Delta I'$ donc son courant de base vaut $\dfrac{I_1 - \Delta I'}{\beta + 1}$ et son courant de collecteur vaut $(I_1 + \Delta I') \dfrac{\beta}{\beta + 1}$, en supposant $T_{11}$ et $T_{12}$ identiques.

Le courant $I_{T21}$ traversant le transistor $T_{21}$ monté en diode vaut donc :

$$I_{T21} = \frac{\beta}{\beta + 1}(I_1 + \Delta I') + \frac{(I_1 - \Delta I')}{\beta + 1} = I_1 + \frac{\beta - 1}{\beta + 1}\Delta I' = I_1 + \Delta I$$

Le courant $I_{T22}$ traversant le transistor $T_{22}$ monté en diode vaut donc :

$$I_{T22} = \frac{\beta}{\beta + 1}(I_1 + \Delta I') + \frac{(I_1 + \Delta I')}{\beta + 1} = I_1 - \frac{\beta - 1}{\beta + 1}\Delta I' = I_1 - \Delta I$$

Ca veut dire que :

$$\frac{\beta - 1}{\beta + 1} - \Delta I' = \Delta I$$

On a

$$\Delta I = \frac{\Delta V - D_3}{R_0}$$

$$\Delta I' = \frac{\Delta V - D_3 - E}{R_2} = \frac{\beta + 1}{\beta - 1}\frac{\Delta V - D3}{R_0}$$

En posant $D_3 = 0$ (distorsion nulle), on obtient :

$$\frac{\Delta V}{R_0} = \frac{\beta - 1}{\beta + 1}\frac{\Delta V - E}{R_2}$$

d'où :

$$R_2 = R_0\frac{\beta - 1}{\beta + 1}(1 - \frac{E}{\Delta V})$$

Ce qui permet d'annuler la distorsion pour une valeur donnée de $\Delta V$ ($E$ dépend de $\Delta V$)

La formule montre que $R_2$ est inférieur à $R_0$, d'où la possibilité de réaliser la compensation par adjonction d'une résistance en parallèle comme déjà indiqué.

Exemple : $R_0 = 800\ \Omega$          $R_2 = 640\Omega$

Soit $R_2/R_0 = 0,8$

$\Delta V\text{max} = 1V$ crête à crête

$D_3\text{max} = 0,3\%$

$D_3 = 0$ pour $\Delta V = 0,8V$

Cette valeur maximale de 0,3% correspond à une précision meilleure que 0,25 bit pour un étage de convertisseur 6 bits utilisé pour un convertisseur 8 bits à repliement et interpolation.

Avec $R_2 = R_0$, la distortion maximale aurait été supérieure à 0,7%.

En pratique le calcul du rapport de $R_2/R_0$ demande de développer les calculs juqu'au $5^{\text{ème}}$ ordre et de tenir également compte de la variation du gain en courant $\beta$ des transistors en fonction du courant ainsi que de l'effet Early.

L'ajustement de ce rapport peut être effectué en traçant les courbes $D_3$ en fonction de $\Delta V$ pour différentes valeurs des rapports $R_2/R_0$ soit avec un montage d'essai, soit avec un simulateur. Dans ce dernier cas, un logiciel utilisable est le programme SPICE II de Berkeley University, lequel est accessible au public ("General Purpose Electronic Simulator").

Les valeurs du rapport $R_2/R_0$ utilisables en pratique sont comprises en général entre 0,65 et 0,85.

Un bon critère est d'ajuster le rapport $R_2/R_0$ pour que les valeurs maximales positives et négatives de la distortion $D_3$ soient égales en valeur absolue.

Pour des circuits fonctionnant dans une gamme de fréquences l'ajustement se fera de préférence à la fréquence maximale d'utilisation.

On notera que dans la technologie des circuits intégrés les rapports entre des résistances sont très précis. En d'autres termes, deux résistances de même valeur nominale diffèrent, selon les technologies actuelles, de moins de 1%. Par contre, la précision sur les valeurs absolues est nettement plus faible. Un avantage de cette compensation est que c'est le rapport entre $R_2$ et $R_0$ qui compte.

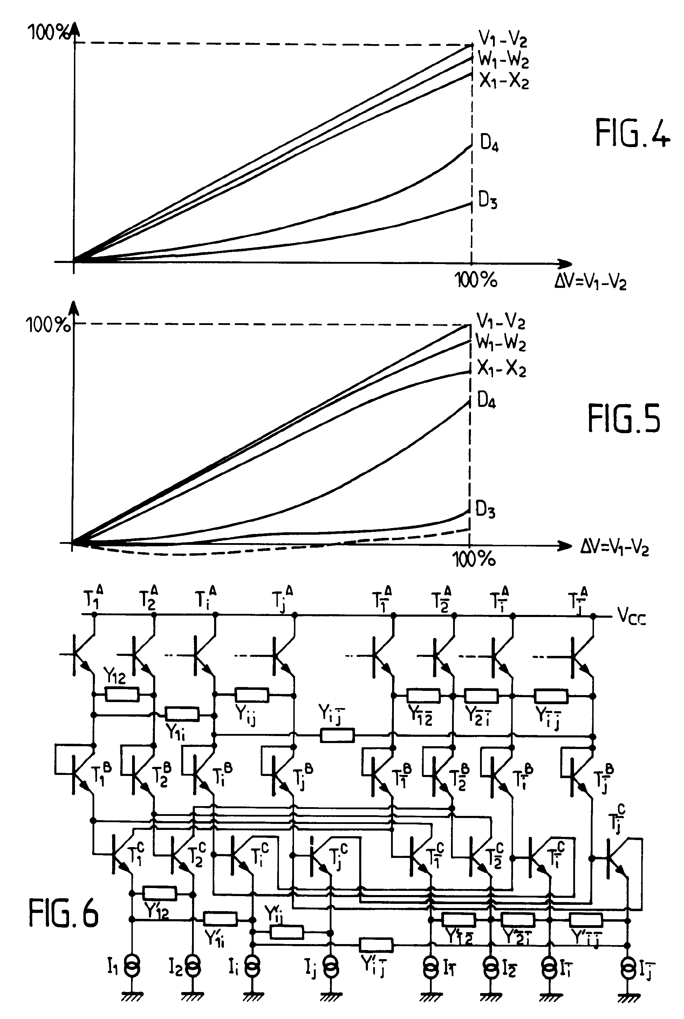

Les figures 4 et 5 représentent $\Delta V (= V_1 - V_2)$, $W_1 - W_2$, $X_1 - X_2$, $D_3$ et $D_4$ en ordonnée en fonction de $\Delta V = V_1 - V_2$ (en abscisse) exprimé en pourcentage de l'amplitude maximale de $\Delta V$. L'échelle de $D_3$ et $D_4$ est dilatée en ordonnée de manière à faire mieux apparaître les variations.

Dans le cas de la figure 4, on a $R_2 = R_0$ (pas de résistance additionnelle $R_1$ ou d'équivalent). La distorsion $D_3$ croît régulièrement en fonction de $\Delta V$.

Dans le cas de la figure 5, on a $R_2 < R_0$ (présence d'une résistance $R_1$ ou équivalent). La distorsion $D_3$ (courbe en traits pleins pour $R_2/R_0 = 0,95$) commence par être légèrement négative, puis s'annule pour un $\Delta V$ donné (voir formule ci-dessus) et la distorsion maximale est plus faible que précédemment. La distorsion $D_4$ est plus importante que dans le cas de la figure 4. On a représenté en pointillé la courbe représentant $D_3$ pour une valeur de $R_2$ plus faible que précédemment et correspondant à l'exemple ci-dessus soit $R_2/R_0 = 0,8$. Pour les valeurs faibles de $\Delta V$, la courbe $D_3$ s'infléchit plus vers les valeurs négatives. $D_3$ passe par la valeur 0 pour une valeur de $\Delta V$ plus grande que précédemment et la distorsion pour $\Delta V = 100\%$ de l'échelle est plus faible que précédemment.

On peut donc en pratique choisir une valeur de $R_2$ permettant d'optimiser la distorsion $D_3$ selon un critère choisi, par exemple distorsion maximale (positive ou négative) inférieure à une valeur donnée, ou bien encore distorsion positive inférieure à une valeur donnée à mi-échelle, les tracés des courbes et la valeur de $R_2$ étant obtenus de préférence par simulation.

La figure 6 représente un circuit associant une pluralité de circuits élémentaires tels que définis ci-dessus, et dans lequel des admittances peuvent être disposées entre les émetteurs de tous les transistors (c'est-à-dire pas seulement ceux d'une même paire).

Soit :

$$(T_1^A, \ T_{\overline{1}}^A), \quad (T_2^A, \ T_{\overline{2}}^A) \ldots \ldots (T_i^A, \ T_{\overline{i}}^A), \quad (T_j^A, \ T_{\overline{j}}^A),$$

les paires de transistors recevant les signaux d'entrée.

$Y_{12}$ désigne une admittance connectée entre les émetteurs des transistors $T_1^A$ et $T_2^A$.

$Y_{\overline{12}}$ désigne une admittance connectée entre les émetteurs des transistors

$$T_{\overline{1}}^A \ \text{et} \ T_{\overline{2}}^A \ .$$

et plus généralement :

$Y_{ij}$ ou $Y_{ji}$ désigne, quelque soient i et j l'admittance d'une impédance (ou d'un réseau) connecté entre les émetteurs des transistors $T_1^A$ et $T_j^A$.

$Y_{\overline{ij}}$ ou $Y_{\overline{ji}}$ désigne quelque soient i et j l'admittance d'une impédance (ou d'un réseau) connectée entre les émetteurs des transistors

$$T_{\overline{i}}^A \ \text{et} \ T_{\overline{j}}^A$$

Soient :

$$T_1^B, \ T_2^B, \ldots T_i^B, \ldots \ T_j^B, \ T_{\overline{1}}^B, \ T_{\overline{2}}^B, \ldots . T_{\overline{i}}^B, \ldots . T_{\overline{j}}^B,$$

les transistors de compensation montés en diode et associés aux transistors précédent ayant le même indice numérique.

Soient enfin :

$$(T_1, \; T_{\bar{1}}^{c}) \; (T_2, \; T_{\bar{2}}^{c}), \ldots (T_i, \; T_{\bar{i}}^{c}) \ldots (T_j, \; T_{\bar{j}}^{c})$$

les paires de transistors à interconnexion base-collecteur croisées, associés aux paires précédentes ayant les deux mêmes indices numériques. $Y'_{12}$ désigne l'admittance d'une impédance ou d'un réseau connectés entre les émetteurs des transistors $T_1^c$ et $T_2^c$ $Y'\overline{_{12}}$ désigne l'admittance d'une impédance ou d'un réseau connecté entre les émetteurs des transistors

$$T_{\bar{1}}^{c} \; et \; T_{\bar{2}}^{c}$$

$Y'_{ij}$ ou $Y'_{ji}$ désigne (quelque soient i,j) l'admittance d'une impédance ou d'un réseau connecté entre les émetteurs des transistors $T_i^c$ et $T_j^c$

$Y'_{\bar{ij}}$ ou $Y'_{\bar{ji}}$ désigne (quelques soient i, j) l'admittance d'une impédance ou d'un réseau connecté entre les émetteurs des transistors

$$T_{\bar{i}}^{c} \; et \; T_{\bar{j}}^{c}$$

Si on suppose que les signaux d'entrée attaquant les transistors d'entrée $(T_1^A \ldots T_j^A$ sont les signaux différentiels ayant tous la même tension de mode commun, on obtient un fonctionnement optimal en respectant les conditions suivantes :

$$Y_{i,j} = Y_{i,\bar{j}}$$

$$Y_{\bar{i},j} = Y_{i,\bar{j}}$$

ce qui assure en effet un équilibre des courants.

De même pour les admittances $Y'$ :

$$Y'_{i,j} = Y'_{i,\bar{j}}$$

$$Y'_{\bar{i},j} = Y'_{i,\bar{j}}$$

Les admittances $Y'_{i,i}$ (c'est à dire disposées entre les émetteurs d'une même paire) d'une valeur nominale supérieure aux admittances $Y_{i,\bar{i}}$ .

## Revendications

1. Circuit différentiel compensé en distortion et comportant d'une part un étage différentiel comprenant un premier $(Q_1, T_1)$ et un deuxième $(Q_2, T_{\bar{1}})$ transistor dont les émetteurs sont couplés par une première impédance $(R'_1, Z)$ ainsi que des bornes d'entrée pour une source de signal d'entrée $(V, V_1, V_2)$, et d'autre part un circuit de compensation de distortion comportant d'une part en série entre l'émetteur du premier transistor $(Q_1, T_1)$ et une première source de courant $(I'_3, I_{\bar{1}})$ une première diode $(Q_7, D_1, T_{22})$ ainsi que le trajet principal de courant d'un troisième transistor $(Q_5, T_{12})$ et d'autre part en série entre l'émetteur du deuxième transistor $(Q_2, T_{\bar{1}})$ et une deuxième source de courant $(I'_4, I_1)$ une deuxième diode $(Q_8, D_2, T_{21})$ ainsi que le trajet de courant principal d'un quatrième transistor $(Q_6, T_{11})$, le troisième $(Q_5, T_{12})$ et le quatrième $(Q_6, T_{11})$ transistors ayant leur base et leur collecteur respectivement interconnectés et ayant leurs émetteurs couplés par une deuxième impédance $(Z')$ caractérisé en ce que la deuxième impédance $(Z', R'_2)$ a une valeur nominale inférieure à celle de la première impédance $(R'_1, Z)$.

2. Circuit selon la revendication 1, caractérisé en ce que la première $(R'_1, Z)$ et la deuxième $(Z', R'_2)$ impédance sont résistives.

3. Circuit selon la revendication 1 ou 2, caractérisé en ce que le rapport de la deuxième impédance et la première impédance est comprise entre les valeurs 0,65 et 0,85.

4. Circuit selon une des revendications 1 à 3, caractérisé en ce que l'étage différentiel est agencé pour constituer, de manière connue en soi, un convertisseur tension-courant, lesdites bornes d'entrée étant disposées en série avec la première impédance ($R'_1$, Z).

5. Circuit selon une des revendications 1 à 4 caractérisé en ce que l'étage différentiel est agencé pour constituer, de manière connue en soi un suiveur différentiel, la base des premier ($T_1$) et deuxième ($\overline{T_1}$) transistors constituant lesdites bornes d'entrée.

6. Circuit suiveur multiple caractérisé en ce qu'il comporte une pluralité de circuits suiveurs différentiels selon la revendication 5, les premier deuxième troisième et quatrième transistor du circuit suiveur différentiel de rang i étant dénommés respectivement

$$T_i^A, \quad T_{\bar{i}}^A, \quad T_i^C \quad \text{et} \quad T_{\bar{i}}^C,$$

en ce qu'il comporte des premières impédances connectées entre les émetteurs d'au moins certains des transistors d'un premier groupe comprenant les premier et deuxième transistor et dont l'admittance est notée Y suivi de deux indices correspondant à ceux des deux transistors dudit premier groupe entre les émetteurs desquels ladite impédance est connectée, et des deuxièmes impédances connectées entre les émetteurs d'au moins certains des transistors d'un deuxième groupe comprenant les troisième et quatrième transistors et dont l'admittance est notée Y' suivi de deux indices correspondant aux deux transistors dudit deuxième groupe entre les émetteurs desquels ladite impédance est connectée, en ce que l'on a, quelques soient i, j, ī et j̄

$$Y_{ij} = Y_{\overline{ij}} > Y'_{i\,j} = Y'^{\overline{}}_{ij}$$
$$Y_{\overline{ij}} = Y_{i\,\overline{j}} > Y'_{\overline{i}\,j} = Y'_{i\,\overline{j}}$$

**Patentansprüche**

1. Differenzschaltung mit Verzerrungsausgleich, die erstens eine Differenzstufe umfaßt mit einem ersten Transistor ($Q_1$, $T_1$) und einem zweiten Transistor ($Q_2$, $\overline{T_1}$), deren Emitter über eine erste Impedanz ($R'_1$, Z) gekoppelt sind, und mit Eingangsklemmen für eine Eingangssignalquelle (V, $V_1$, $V_2$) und zweitens eine Verzerrungsausgleichsschaltung umfaßt, die erstens in Reihe zwischen dem Emitter des ersten Transistors ($Q_1$, $T_1$) und einer ersten Stromquelle ($I'_3$, $\overline{I_1}$) eine erste Diode ($Q_7$, $D_1$, $T_{22}$) sowie den Hauptstrompfad eines dritten Transistors ($Q_5$, $T_{12}$) umfaßt und zweitens in Reihe zwischen dem Emitter des zweiten Transistors ($Q_2$, $\overline{T_1}$) und einer zweiten Stromquelle ($I'_4$, $I_1$) eine zweite Diode ($Q_8$, $D_2$, $T_{21}$) sowie den Hauptstrompfad eines vierten Transistors ($Q_6$, T1$_1$) umfaßt, wobei die Basis und der Kollektor des dritten Transistors ($Q_5$, $T_{12}$) und des vierten Transistors ($Q_6$, $T_{11}$) jeweils miteinander verbunden und ihre Emitter über eine zweite Impedanz (Z') gekoppelt sind, dadurch gekennzeichnet, daß die zweite Impedanz (Z', $R'_2$) einen Nennwert aufweist, der niedriger ist als derjenige der ersten Impedanz ($R'_1$, Z).

2. Schaltung nach Anspruch 1, dadurch gekennzeichnet, daß die erste Impedanz ($R'1$, Z) und die zweite Impedanz (Z', $R'_2$) Widerstände sind.

3. Schaltung nach Anspruch 1 oder 2, dadurch gekennzeichnet, daß das Verhältnis von zweiter zu erster Impedanz zwischen den Werten 0,65 und 0,85 liegt.

4. Schaltung nach einem der Ansprüche 1 bis 3, dadurch gekennzeichnet, daß die Differenzstufe so eingerichtet ist, daß sie auf an sich bekannte Weise einen Spannung/Strom-Umsetzer bildet, wobei die genannten Eingangsklemmen mit der ersten Impedanz ($R'_1$, Z) in Reihe angeordnet sind.

5. Schaltung nach einem der Ansprüche 1 bis 4, dadurch gekennzeichnet, daß die Differenzstufe so eingerichtet ist, daß sie auf an sich bekannte Weise einen Differenzfolger bildet, wobei die Basis der ersten Transistors ($T_1$) und des zweiten Transistors ($T_2$) die genannten Eingangsklemmen bilden.

6. Mehrfachfolgerschaltung, dadurch gekennzeichnet, daß sie mehrere Differenzfolgerschaltungen nach Anspruch 5 umfaßt, wobei der erste, zweite, dritte und vierte Transistor der Differenzfolgerschaltung mit Rang i jeweils mit

$$T^A_i,\ T^A_{\bar{i}},\ T^C_i\ \text{und}\ T^C_{\bar{i}}$$

bezeichnet werden, daß sie zwischen die Emitter von wenigsten bestimmten der Transistoren einer ersten Gruppe mit dem ersten und zweiten Transistor geschaltete erste Impedanzen umfaßt, deren Admittanz mit Y und zwei darauffolgenden Indizes bezeichnet wird, die denjenigen der zwei Transistoren aus der genannten ersten Gruppe entsprechen, zwischen deren Emitter die genannte Impedanz geschaltet ist, und daß sie zwischen die Emitter von wenigsten bestimmten der Transistoren einer zweiten Gruppe mit dem dritten und vierten Transistor geschaltete zweite Impedanzen umfaßt, deren Admittanz mit Y' und zwei darauffolgenden Indizes bezeichnet wird, die denjenigen der zwei Transistoren aus der genannten zweiten Gruppe entsprechen, zwischen deren Emitter die genannte Impedanz geschaltet ist, und daß man für beliebige i, j, ī und j̄ folgendes erhält:

$$Y_{ij} = Y_{\bar{j}} -> Y'_{ij} = Y'_{\bar{j}}$$
$$Y_{i\bar{j}} = Y_{j} -> Y'_{i\bar{j}} = Y'_{j}$$

## Claims

1. A distortion-compensated differential circuit which comprises, on the one hand, a differential stage comprising a first ($Q_1$, $T_1$) and a second ($Q_2$, $T_{\bar{1}}$) transistor whose emitters are coupled by a first impedance ($R'_1$, Z), and input terminals for an input signal source (V, $V_1$, $V_2$) and, on the other hand, a distortion compensation circuit comprising, on the one hand, in series between the emitter of the first transistor ($Q_1$, $T_1$) and a first current source ($I'_3$, $I_{\bar{1}}$) a first diode ($Q_7$, $D_1$, $T_{22}$) as well as the main current path of a third transistor ($Q_5$, $T_{12}$) and, on the other hand, in series between the emitter of the second transistor ($Q_2$, $T_{\bar{1}}$) and a second current source ($I'_4$, $I_1$) a second diode ($Q_8$, $D_2$, $T_{21}$) as well as the main current path of a fourth transistor ($Q_6$, $T_{11}$), which third ($Q_5$, $T_{12}$) and which fourth ($Q_6$, $T_{11}$) transistor have their respective bases and collectors interconnected and have their emitters coupled by a second impedance (Z'), characterised in that the second impedance (Z', $R'_2$) has a nominal value smaller than that of the first impedance ($R'_1$, Z).

2. A circuit as claimed in Claim 1, characterised in that the first ($R'_1$, Z) and the second (Z', $R'_2$) impedance are resistive.

3. A circuit as claimed in Claim 1 or 2, characterised in that the ratio between the second impedance and the first impedance lies between the values 0.65 and 0.85.

4. A circuit as claimed in any one of the Claims 1 to 3, characterised in that the differential stage is arranged to form a voltage-current converter in a manner known *per se*, said input terminals being arranged in series with the first impedance ($R'_1$, Z).

5. A circuit as claimed in any one of the Claims 1 to 4, characterised in that the differential stage is arranged to form a differential follower, the bases of the first ($T_1$) and the second ($T_{\bar{1}}$) transistor forming said input terminals.

6. A multiple follower circuit, characterised in that it comprises a plurality of differential follower circuits as claimed in Claim 5, the first, the second, the third and the fourth transistor of the differential follower circuit of the rank *i* being denominated

$$T^A_i,\ T^A_{\bar{i}},\ T^C_i\ \text{and}\ T^C_{\bar{i}}\ ,$$

respectively, in that it comprises first impedances connected between the emitters of at least some of the transistors of a first group comprising the first and the second transistor, the admittance of said first impedances being designated Y followed by two indexes corresponding to those of the two transistors of said first group between whose emitters said impedance is connected, and second impedances connected between the emitters of at least some of the transistors of a second group comprising the third and the fourth transistor, the admittance of said second impedances being designated Y′ followed by two indexes corresponding to those of the two transistors of said second group between whose emitters said impedance is connected, and regardless of $i, j, \bar{i}$ and $\bar{j}$ the following is valid

$$Y_{ij} = Y_{\bar{i}\,\bar{j}} > Y'_{ij} = Y'_{\bar{i}\,\bar{j}}$$
$$Y_{ij} = Y_{i\bar{j}} > Y'_{ij} = Y'_{ij}.$$

FIG.1

FIG. 2

FIG. 3

FIG.4

FIG.5

FIG.6